# EUROPÄISCHE PATENTSCHRIFT

(11) **EP 1 556 899 B1**
(45) Veröffentlichungstag und Bekanntmachung des Hinweises auf die Patenterteilung: **12.08.2015**
(21) Anmeldenummer: 03753282.7
(22) Anmeldetag: 09.09.2003
(51) Int. Cl.: H01L 23/485, H01L 23/522, H01L 23/00

(54) **ELEKTRONISCHES BAUELEMENT MIT INTEGRIERTEM PASSIVEN ELEKTRONISCHEN BAUELEMENT UND VERFAHREN ZU DESSEN HERSTELLUNG**
ELECTRONIC COMPONENT WITH AN INTEGRATED PASSIVE ELECTRONIC COMPONENT AND METHOD FOR PRODUCTION THEREOF
COMPOSANT ELECTRONIQUE A COMPOSANT ELECTRONIQUE PASSIF INTEGRE ET PROCEDE DE FABRICATION DUDIT COMPOSANT

(30) Priorität: 22.10.2002 DE 10249192
(43) Veröffentlichungstag der Anmeldung: 27.07.2005
(73) Patentinhaber: Infineon Technologies AG, 85579 Neubiberg (DE)
(72) Erfinder: BARTH, Hans-Joachim, 81245 München (DE)
(74) Vertreter: Patentanwälte Lambsdorff & Lange
(86) Internationale Anmeldenummer: PCT/DE2003/002987
(87) Internationale Veröffentlichungsnummer: WO 2004/040646

(56) Entgegenhaltungen:
- EP-A- 0 973 198
- EP-A- 1 143 513
- US-A- 5 751 065
- US-A1- 2001 010 408
- US-A1- 2002 142 512
- US-B1- 6 313 024

## Beschreibung

Die Erfindung betrifft ein elektronisches Bauelement mit einem integrierten elektronischen Bauelement.

In den meisten analogen Schaltungsteilen gemischt digitalanaloger Schaltungen werden passive Bauelemente, bspw. Kondensatoren mit hohem Kapazitätswert, großer Linearität und hoher Güte, benötigt. Um die Kosten der Herstellung des Bauelements möglichst gering zu halten, ist es erforderlich, dass die Herstellung der passiven Bauelemente, insbesondere Kapazitäts- oder Induktivitätsstrukturen, möglichst wenig Prozessschritte erfordern. Des Weiteren ist mit der fortschreitenden Miniaturisierung der Bauelemente und integrierten Schaltungen auch die Forderung nach möglichst wenig Flächenbedarf für diese integrierten passiven Bauelemente einhergehend.

Aus der Patentschrift US 5,583,359 ist eine Kapazitätsstruktur für einen integrierten Schaltkreis bekannt. Dort wird eine Mehrzahl an Metallplatten, welche die Elektroden eines Stapelkondensators bilden, durch dielektrische Schichten getrennt, übereinander angeordnet. In jeder Ebene einer Metallplatte ist eine von der jeweiligen Platte isolierte Metalleitung angeordnet. Die Metallleitungen sind jeweils von beiden Seiten mit Via-Verbindungen kontaktiert, wodurch zum einen alle ungeradzahlig und zum anderen alle geradzahlig in dem Stapel positionierten Platten elektrisch miteinander verbunden werden. Indem die geradzahlig positionierten Platten an eine erste Anschlussleitung und die ungeradzahlig positionierten Platten an eine zweite Anschlussleitung angelegt werden, weisen benachbarte Platten unterschiedliches Potenzial auf und bilden jeweils paarweise Elektroden eines Plattenkondensators. Die Kapazitätsoberfläche wird somit durch die Plattenoberflächen gebildet. Eine alternative Ausführung der Elektroden ist dadurch gegeben, dass die Platten als streifenförmige Leitungen, die parallel zueinander angeordnet sind, ausgebildet sind.

Weitere mögliche Ausgestaltungen von Kapazitätsstrukturen sind in Aparicio, R. und Hajimiri, A.: Capacity Limits and Matching Properties of Integrated Capacitors; IEEE Journal of Solid-State Circuits, Vol. 37, No. 3, 2002, S. 384 - 393 bekannt, die dort in den Figuren 5 bis 10 perspektivisch dargestellt sind.

Weiter ist es bei neuartigen Chips, in denen dielektrische Bereiche ausgebildet sind, deren Materialien niedrige Dielektrizitätskonstanten aufweisen (bspw. SiLK (organisches Material mit einer Dielektrizitätskonstante von 2.65), Black Diamond, Coral (beides kohlenstoffdotierte Oxide mit einer Dielektrizitätskonstante kleiner 3) oder poröse Ausbildungen dieser Dielektrika) erforderlich, mechanische Verstärkungen auszubilden, um bei mechanischer Krafteinwirkung auf das Bauelement eine Schädigung aufgrund der geringen Härte dieser dielektrischen Materialien zu vermeiden.

Bauelemente, in denen sowohl passive Bauelemente als auch mechanische Stützstrukturen erforderlich sind, benötigen daher relativ viel Platz. Darüber hinaus wird die mechanische Stützstruktur nach dem Fertigstellen des Bauelements, insbesondere nach dem Bonden und der Montage des Bauelements in das Gehäuse, nicht mehr benötigt.

EP 0 973 198 A2 zeigt ein Bauelement mit mehreren übereinander angeordneten Metallisierungsebenen, die jeweils durch Isolationsschichten voneinander getrennt sind. Unter einem Bondbereich ist in einer Metallschicht eine Stützstruktur ausgebildet. In darunterliegenden Metallschichten sind jeweils teilweise Stützstrukturen und teilweise passive Bauelemente als Kapazitäten ausgebildet.

US 6,313,024 B1 zeigt ein elektronisches Bauelement mit metallischen Stützstrukturen unter einem Bondbereich, während EP 1 143 513 A1 ein elektronisches Bauelement zeigt, das Bypass-Kondensatoren, die unter einem Bondbereich angeordnet sind, aufweist.

US 2002/0142512 A1 zeigt mikroelektronische, spiralförmige Induktivitäten. US 2001/0010408 A1 zeigt einen Stapel aus Metallschichten, die jeweils durch eine Isolationsschicht voneinander getrennt sind, und eine parasitäre Kapazität eines Bondpads verringern.

US 5,751,065 zeigt ein elektronisches Bauelement, das eine Abschirmstruktur unter einem Bondbereich aufweist, die sowohl Kriechströme verhindert als auch ein Dielektrikum stützt.

Aufgabe der Erfindung ist es daher, ein elektronisches Bauelement mit einem integrierten passiven elektronischen Bauelement und ein Verfahren zu dessen Herstellung zu schaffen, welches relativ aufwandsarm und platzsparend hergestellt werden kann und robust gegenüber einer mechanischen Krafteinwirkung ist.

Diese Aufgabe wird durch ein elektronisches Bauelement mit den Merkmalen des Patentanspruchs 1 gelöst.

Ein erfindungsgemäßes elektronisches Bauelement weist eine erste Isolationsschicht auf, auf der eine obere Metallschicht ausgebildet ist. Die obere Metallschicht ist insbesondere als elektrisch leitende Bond-Pad-Schicht ausgebildet, an die beispielsweise Aluminium- oder Golddrähte zur elektrischen Verbindung der Kontaktgebiete des elektronischen Bauelements bzw. des Chips mit den Kontaktbahnen eines Gehäuses, in das das elektronische Bauelement montiert wird, gebondet werden. In der ersten Isolationsschicht ist eine elektrisch leitende Struktur integriert, die die erste Isolationsschicht bei mechanischer Krafteinwirkung, insbesondere beim Bonden der oberen Metallschicht und/oder der Montage des elektronischen Bauelements, mechanisch stabilisiert. Die elektrisch leitende Struktur ist zusätzlich als Kapazitätsstruktur ausgebildet.

Dadurch kann ein elektronisches Bauelement erzeugt werden, welches relativ geringen Platzbedarf benötigt und relativ aufwandsarm realisiert werden kann. Die elektrisch leitende Struktur im elektronischen Bauelement dient einerseits als mechanische Stützstruktur bei mechanischer Krafteinwirkung auf das Bauelement, insbesondere als mechanische Stützstruktur für die erste Isolationsschicht, und andererseits als passives Bauelement des elektronischen Bauelements. Durch diese Einzelstruktur mit einer Doppelfunktion werden die Prozessschritte bei der Herstellung und somit die Fertigungskosten reduziert, da keine separate Herstellung von mechanischer Stütz- bzw. Stabilitätsstrukur und passiven Bauelementstrukturen erforderlich ist.

In einem bevorzugten Ausführungsbeispiel ist die erste Isolationsschicht als dielektrische Schicht aus einem Material deren Dielektrizitätskonstante einen Wert kleiner 4 aufweist, ausgebildet. Beispielsweise weist die Dielektrizitätskonstante von SiLK, einem organischen Material, den Wert 2.65 auf. Andere Materialien können beispielsweise Coral oder Black Diamond sein, welche kohlenstoffdotierte Oxide sind und einen Dielektrizitätswert von kleiner 3 aufweisen. Aufgrund des kleinen Modulus und der geringen Härte dieser Materialien können bereits relativ geringe mechanische Kräfte zu Schädigungen führen, wodurch sich daher in diesem Fall die integrierte elektrisch leitende Struktur als mechanische Stabilisierung als besonders vorteilhaft erweist. Die erste Isolationsschicht kann auch als ein Mehrschichtsystem ausgebildet werden, bei dem die einzelnen Schichten teilweise auch höhere Dielektrizitätskonstanten als 4 aufweisen. Wesentlich ist es in diesem Fall, dass das Mehrschichtsystem eine mittlere Dielektrizitätskonstante aufweist, deren Wert kleiner 4, insbesondere kleiner 3 ist.

In einem vorteilhaften Ausführungsbeispiel ist die elektrisch leitende Struktur im wesentlichen vertikal unterhalb eines Bonding-Bereichs der oberen Metallschicht angeordnet. Der Bonding-Bereich, welcher im wesentlichen denjenigen Bereich der oberen Metallschicht bezeichnet, in dem die elektrischen Verbindungen, insbesondere die Kontaktdrähte, zum Herstellen des elektrischen Kontakts mit den Kontaktbahnen des Gehäuses angeordnet sind, kann in vielfältiger Weise realisiert werden. Durch die direkte Anordnung der elektrisch leitenden Struktur unterhalb dieses Bonding-Bereichs kann eine optimierte mechanische Stabilität ermöglicht werden. Besonders bevorzugt ist es, wenn die Ausmaße der elektrisch leitenden Struktur in einer Ebene parallel zur oberen Metallschicht mindestens die Ausmaße des Bonding-Bereichs aufweist. Unabhängig davon, wo ein Bonden bzw. eine mechanische Krafteinwirkung auf den Bonding-Bereich einwirkt, kann daher die erste Isolationsschicht bzw. das gesamte elektronische Bauelement vor mechanischer Beschädigung oder Zerstörung geschützt werden.

Besonders vorteilhaft ist es, die elektrisch leitende Struktur derart in der ersten Isolationsschicht anzuordnen, dass die elektrisch leitende Struktur mit den horizontalen Ebenen der ersten Isolationsschicht im wesentlichen bündig ist. Somit ist die elektrisch leitende Struktur derart in der ersten Isolationsschicht ausgebildet, dass Teilbereiche der horizontalen Oberflächen der ersten Isolationsschicht durch Oberflächenbereiche der elektrisch leitenden Struktur gebildet sind. Die elektrisch leitende Struktur ist dabei in vertikaler Richtung mit maximaler Ausdehnung in der ersten Isolationsschicht ausgebildet (erste Isolationsschicht und elektrisch leitende Struktur weisen im wesentlichen identische Ausmaße in vertikaler Richtung auf). Dadurch kann die mechanische Stabilität nochmals verbessert.werden, da kein mechanisch weniger stabiler oder "weicher" Bereich der ersten Isolationsschicht unterhalb des Bonding Bereichs vorhanden ist, der nicht durch die elektrisch leitende Struktur gestützt ist.

Eine weitere vorteilhafte Ausführungsform kennzeichnet sich dadurch, dass die elektrisch leitende Struktur mittels Via-Verbindungen über einen in einer weiteren Metallisierungsebene ausgebildeten Metallstreifen, insbesondere Kontakt-Metallstreifen, mit einem Versorgungsspannungspotenzial und mittels Via-Verbindungen über einen weiteren in einer Metallisierungsebene ausgebildeten Metallstreifen mit Massepotenzial verbunden sind. Es kann vorgesehen sein, dass beide Kontaktstreifen in einer zweiten Isolationsschicht ausgebildet sind, die aus einem Material mit einer hohen mechanischen Stabilität im Vergleich zur mechanischen Stabilität des Materials der ersten Isolationsschicht hergestellt ist. Der elastische Modulus des Materials der zweiten Isolationsschicht weist bevorzugt einen Wert größer 15 Gigapascal, insbesondere einen Wert größer 20 Gigapascal auf, bzw. eine Härte größer 4 auf. Es kann aber auch vorgesehen sein, dass lediglich einer oder keiner der Kontaktstreifen in der zweiten Isolationsschicht ausgebildet ist. Dies ist abhängig von der Geometrie der elektrisch leitenden Struktur und der damit verbundenen Anordnung der Kontakt-Metallstreifen. Indem zumindest ein Metallstreifen, mit denen eine elektrische Kontaktierung der elektrisch leitenden Struktur an Spannungspotenziale ermöglicht wird, in einer zweiten Isolationsschicht aus einem Material mit hoher mechanischer Stabilität ausgebildet wird, wird eine zusätzliche Stabilisierung des elektronischen Bauelements bei mechanischer Krafteinwirkung, insbesondere auf den Bonding-Bereich der oberen Metallschicht, erreicht. Als zweite Isolationsschicht kann eine Oxidschicht oder eine Schicht aus FSG (Fluor-Silikat-Glass)-Dielektrikum ausgebildet werden.

Zwischen der oberen Metallschicht und der elektrisch leitenden Struktur ist eine elektrisch leitende Abschirmschicht ausgebildet. Die elektrisch leitende Abschirmschicht ist sowohl von der oberen Metallschicht als auch von der elektrisch leitenden Struktur isoliert. In vorteilhafter Weise kann die Abschirmschicht als Metallschicht ausgebildet sein, die bevorzugt mit Massepotenzial verbunden ist. Dadurch kann erreicht werden, dass die an die obere Metallschicht angelegten Signale nicht in die darunter liegende elektrisch leitende Struktur koppeln können und die an die elektrisch leitende Struktur bzw. an das passive Bauelement angelegten Signale nicht in die obere Metallschicht koppeln können.

Vorteilhaft ist es, die Abschirmschicht in einer dritten Isolationsschicht auszubilden, wobei die dritte Isolationsschicht zwischen der oberen Metallschicht und der ersten Isolationsschicht angeordnet ist. Indem die dritte Isolationsschicht bevorzugt als Oxid-Schicht ausgebildet ist, kann eine weitere mechanische Verstärkung der ersten Isolationsschicht erzielt werden. Die Abschirmschicht kann als zusammenhängende Platte oder als Gitterstruktur ausgebildet sein.

Eine besonders effektive elektrische Abschirmung kann dann erzielt werden, wenn die Abschirmschicht in vorteilhafter Weise derart ausgebildet ist, dass die der elektrisch leitenden Struktur zugewandte Fläche der Abschirmschicht mindestens ebenso groß ist wie die der Abschirmschicht zugewandten Fläche der elektrisch leitenden Struktur. Die Abschirmschicht ist bevorzugt derart auf der elektrisch leitenden Struktur ausgebildet, dass bei einer Draufsicht auf die Abschirmschicht der Umriss der Fläche der Abschirmschicht den Unmriss der Fläche der elektrisch leitenden Struktur bedeckt.

Die elektrisch leitende Struktur ist als Kapazitätsstruktur ausgebildet. Es kann dabei vorgesehen sein, dass die elektrisch leitende Struktur vollständig als Kapazität hergestellt ist. Die elektrisch leitende Struktur kann aber auch aus mehreren Teil-Strukturen bestehen, wobei eine Teil-Struktur als Kapazität und eine weitere Teil-Struktur als Induktivität in der ersten Isolationsschicht angeordnet sind. Die elektrisch leitende Struktur ist als Kapazitätsstruktur ausgebildet, die sich über mindestens zwei Metallisierungsebenen erstreckt und in jeder Metallisierungsebene parallel zueinander und elektrisch isoliert voneinander angeordnete Metallstreifen ausgebildet sind. Die Metallstreifen der ersten Metallisierungsebene sind im Wesentlichen deckungsgleich zu den Metallstreifen der zweiten Metallisierungsebene angeordnet und mit Via-Verbindungen in vertikaler Richtung elektrisch miteinander verbunden.

Ein weiteres vorteilhaftes Ausführungsbeispiel ist dadurch gegeben, dass zumindest eine Teil-Struktur der elektrisch leitenden Struktur als Induktivitätsstruktur ausgebildet ist und mindestens eine Metallisierungsebene aufweist, in der eine spiralenförmige Metallbahn ausgebildet ist.

Die obere Metallschicht ist über ein Kontaktloch in der zweiten Isolationsschicht mit einem darunter, insbesondere in der dritten Isolationsschicht ausgebildeten elektrisch leitenden Bereich kontaktiert. Das Kontaktloch ist im Bereich außerhalb des Bonding-Bereichs der oberen Metallschicht angeordnet und ist ebenso wie der elektrisch leitende Bereich horizontal versetzt zur elektrisch leitenden Struktur angeordnet.

In einem bevorzugten Ausführungsbeispiel ist das erfindungsgemäße elektronische Bauelement auf einem Substrat in einer integrierten Schaltung angeordnet.

Bei einem nicht erfindungsgemäßen Verfahren zum Herstellen eines elektronischen Bauelements wird in einer erste Isolationsschicht eine elektrisch leitende Struktur als zumindest ein passives elektronisches Bauelement und als mechanische Stabilisierungsstruktur zum Stützen der ersten Isolationsschicht bei mechanischer Krafteinwirkung ausgebildet. Auf der ersten Isolationsschicht wird eine obere Metallschicht, die insbesondere als elektrisch leitende Bond-Pad-Schicht ausgebildet wird, erzeugt, auf die insbesondere beim Bonden bzw. bei der Montage des elektronischen Bauelements mechanische Krafteinwirkungen ausgeübt werden.

In einfacher und aufwandsarmer Weise wird dadurch eine Struktur erzeugt, die eine Doppelfunktion für das elektronische Bauelement besitzt. Dadurch kann das elektronische Bauelement platzsparend und kostengünstig realisiert werden.

In einem nicht zur Erfindung gehörigen Beispiel wird die erste Isolationsschicht aus einem Material mit einer Dielektrizitätskonstante kleiner 4, insbesondere kleiner 3, ausgebildet. Besonders bei derart mechanisch instabilen und relativ empfindlichen Materialien gegenüber mechanischer Krafteinwirkung kann dadurch eine erhebliche Verbesserung der mechanischen Stabilität erreicht werden.

Besonders vorteilhaft ist es, die elektrisch leitende Struktur unterhalb eines Bonding-Bereichs der oberen Metallschicht auszubilden, da durch die Montage bzw. das Bonden des elektronischen Bauelements besonders in dem Bereich unterhalb des Bonding-Bereichs große mechanische Kräfte wirken und zu Beschädigung und Zerstörung führen können.

Weitere vorteilhafte Ausgestaltungen der Erfindung sind in den Unteransprüchen angegeben.

Nachfolgend wird ein Ausführungsbeispiel anhand der schematischen Zeichnungen näher erläutert. Es zeigen:
- Fig. 1: eine Schnittdarstellung eines erfindungsgemäßen elektronischen Bauelements;
- Fig. 2: eine perspektivische Darstellung eines ersten Ausführungsbeispiels einer elektrisch leitenden Struktur des erfindungsgemäßen elektronischen Bauelements;
- Fig. 3: eine Draufsicht auf ein nicht zur Erfindung gehöriges Beispiel einer elektrisch leitenden Struktur des erfindungsgemäßen elektronischen Bauelements;
- Fig. 4: eine perspektivische Darstellung eines Ausschnitts der elektrisch leitenden Struktur gemäß Fig. 3.

In den Figuren werden gleiche oder funktionsgleiche Elemente mit denselben Bezugszeichen versehen.

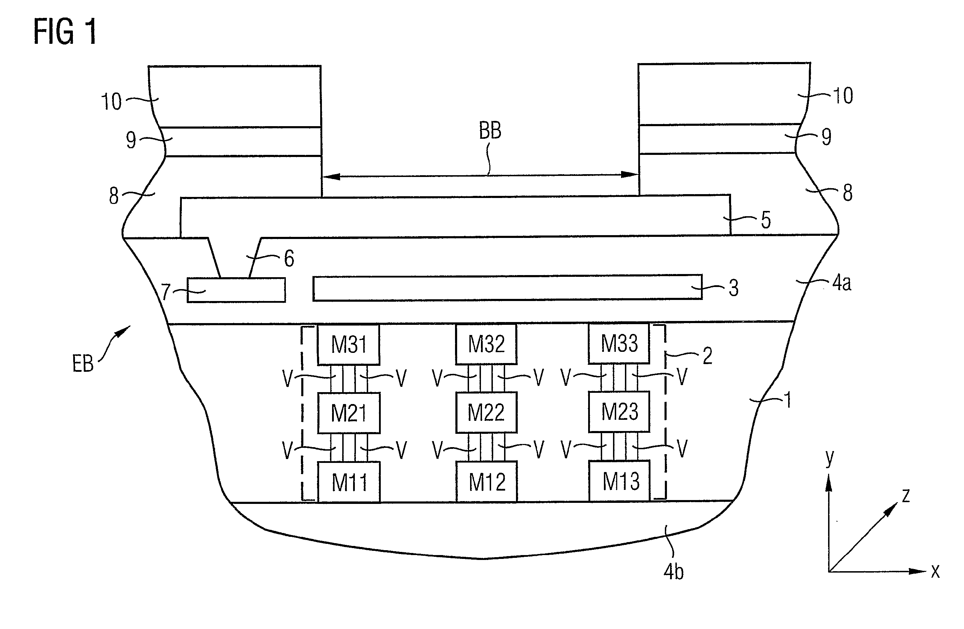

Ein elektronisches Bauelement EB (Fig. 1) weist eine erste Isolationsschicht 1 auf, die im Ausführungsbeispiel aus einem Material mit niedriger Dielektrizitätskonstante ausgebildet ist. In diese erste Isolationsschicht 1 ist eine elektrisch leitende Struktur 2 integriert. Die elektrisch leitende Struktur 2 ist als Kapazitätsstruktur ausgebildet und aus den Metallstreifen M11 bis M33 aufgebaut. Die Metallstreifen M11 bis M33 erstrecken sich in z-Richtung parallel zueinander, wobei die Metallstreifen M11 bis M13, die Metallstreifen M21 bis M23 und die Metallstreifen M31 bis M33 jeweils in einer Metallisierungsebene ausgebildet sind. Die Metallstreifen M11, M21 und M31 sind deckungsgleich zueinander angeordnet und mittels Via-Verbindungen V elektrisch miteinander verbunden. Dies trifft in analoger Weise auch auf die Metallstreifen M12, M22 und M32 sowie M13, M23 und M33 zu. Die Metallstreifen M11, M21 und M31 sowie M13, M23 und M33 sind mit einem Versorgungsspannungspotenzial - Gleich- oder Wechselspannung - verbunden. Die Metallstreifen M12, M22 und M32 sind mit Massepotenzial verbunden. Die Kapazitätsstruktur ist derart in der ersten Isolationsschicht 1 angeordnet, dass die Metallstreifen M11, M12 und M13 mit der unteren horizontalen Oberfläche der ersten Isolationsschicht 1 eben abschließen. Ebenso sind die Metallstreifen M31, M32 und M33 mit ihren Oberflächen derart in die erste Isolationsschicht 1 eingebettet, dass sie eine ebene Oberfläche mit der oberen horizontalen Ebene der ersten Isolationsschicht 1 in der x-z-Ebene bilden und im Wesentlichen das gleiche Höhenniveau aufweisen. Angrenzend an die erste Isolationsschicht 1 ist eine weitere Isolationsschicht 4b angeordnet, die aus einem Material mit einer hohen mechanischen Stabilität im Vergleich zur mechanischen Stabilität des Materials der ersten Isolationsschicht 1 ausgebildet ist. In dieser Isolationsschicht 4b sind Bauelemente, bspw. Transistoren ausgebildet. Diese Schicht 4b ist auf einem nicht dargestellten Substrat ausgebildet.

Die als Kapazitätsstruktur ausgebildete Struktur 2 kann neben der im Ausführungsbeispiel dargestellten Form auch - nicht zur Erfindung gehörig - in vielfältiger Weise ausgebildet sein. Als weitere Gestaltungsmöglichkeiten seien die Strukturen in Aparicio, R. und Hajimiri, A.: Capacity Limits and Matching Properties of Integrated Capacitors; IEEE Journal of Solid-State Circuits, Vol. 37, No. 3, 2002, S. 384 - 393 erwähnt, die dort in den Figuren 5 bis 10 perspektivisch dargestellt sind. Die Kapazitätsstruktur 2 kann auch - nicht zur Erfindung gehörig - als Grid-Struktur oder als MOS-Struktur in einem Halbleiterbauelement realisiert sein.

Auf dieser Struktur 2 ist eine elektrisch leitende Abschirmschicht 3 als Metallschicht ausgebildet, die in einer dritten Isolationsschicht 4a angeordnet ist. Die als Platte ausgebildete Abschirmschicht 3 ist derart in der dritten Isolationsschicht 4a angeordnet, dass die Struktur 2 vollständig unterhalb der Abschirmschicht 3 angeordnet ist. Die dritte Isolationsschicht 4a ist im Ausführungsbeispiel als Oxid-Schicht ausgeführt. Auf der dritten Isolationsschicht 4a ist eine obere Metallschicht 5 als Bond-Pad-Schicht ausgebildet. Die Bond-Pad-Schicht 5 ist über ein in der dritten Isolationsschicht 4a ausgebildetes Kontaktloch 6 mit einem elektrisch leitenden Bereich 7 verbunden. Sowohl das Kontaktloch 6 als auch der elektrisch leitende Bereich 7 sind außerhalb eines Bonding-Bereichs BB der Bond-Pad-Schicht 5 angeordnet. Um eine optimale mechanische Verstärkung bzw. Stabilisierung der ersten Isolationsschicht 1 in Bezug auf die beim Bonden und/oder bei der Montage des elektronischen Bauelements EB in ein Gehäuse auftretenden Krafteinwirkungen zu erhalten, ist die Struktur 2 im Wesentlichen unterhalb des Bonding-Bereichs BB angeordnet. Der Bonding-Bereich BB wird durch Entfernen, bspw. durch Belichten bzw. Ätzen, der auf der Bond-Pad-Schicht 5 ausgebildeten Schicht 10 bzw. der Oxid- und NitridSchichten 8 und 9 erzeugt. Die Schicht 10 ist im Ausführungsbeispiel als PSPI-Schicht (Photo-Sensitive Polyemid-Schicht) ausgebildet.

Die Abschirmschicht 3 ist mit Massepotenzial verbunden, so dass ein Koppeln eines an der Bond-Pad-Schicht 5 anliegenden Signals in die Struktur 2 oder ein Koppeln eines an der Struktur 2 anliegenden Signals in die Bond-Pad-Schicht 5 verhindert werden kann.

Ist im dargestellten Ausführungsbeispiel (Fig. 1) keine Abschirmschicht 3 ausgebildet, kann auch nicht zur Erfindung gehörig vorgesehen sein, den elektrisch leitenden Bereich 7 in derjenigen Metallisierungsebene auszubilden, in der auch die Metallstreifen M31 bis M33 angeordnet sind.

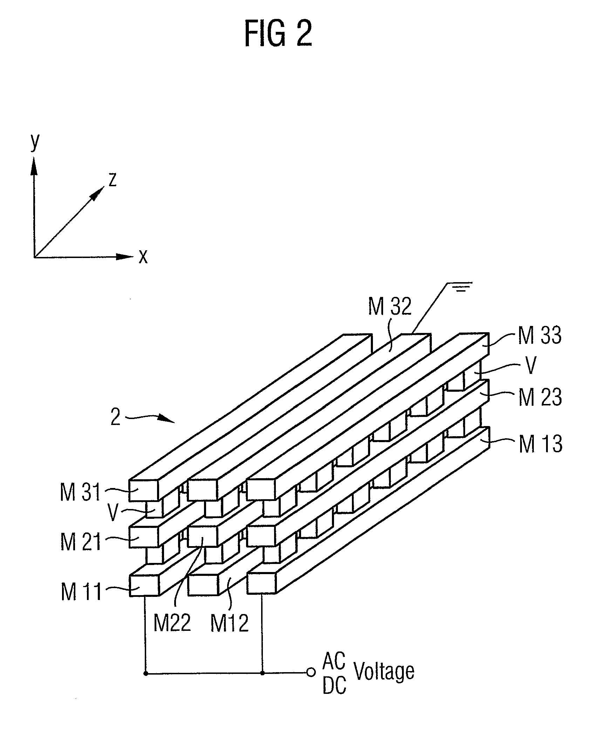

In Fig.2 ist eine perspektivische Darstellung der Kapazitätsstruktur 2 gezeigt, wobei die Metallstreifen M11, M21 und M31, die Metallstreifen M12, M22 und M32 sowie die Metallstreifen M13, M23 und M33 in y-Richtung betrachtet über jeweils nur eine Via-Verbindung V kontaktiert sind. Die elektrische Verbindung der Metallstreifen M12, M22 und M32 mit Massepotenzial und die elektrische Verbindung der Metallstreifen M11, M21, M31, M13, M23 und M33 mit Versorgungsspannungspotenzial erfolgt über nicht dargestellte Via-Verbindungen und nicht dargestellte Metallstreifen KM. Zumindest die Metallstreifen KM sind beide in einer zweiten, nicht dargestellten Isolationsschicht ausgebildet, die eine höhere mechanische Stabilität als die erste Isolationsschicht 1 (Fig. 1) aufweist. Die zweite Isolationsschicht ist mit der in Fig. 1 dargestellten dritten Isolationsschicht 4 identisch. Das Material der zweiten Isolationsschicht weist eine höhere mechanische Stabilität als das Material der ersten Isolationsschicht 1 auf. Die zweite Isolationsschicht kann beispielweise als Oxidschicht oder als Schicht aus einem FSG-Dielektrikum hergestellt sein. Es kann aber auch sein, dass lediglich einer der Kontaktstreifen KM in der zweiten Isolationsschicht ausgebildet ist.

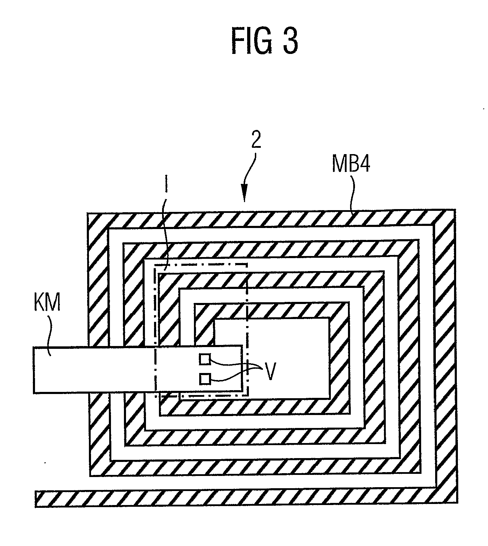

In Fig. 3 ist eine Draufsicht (in negative y-Richtung betrachtet) auf ein Beispiel einer elektrisch leitenden Struktur 2 eines nicht erfindungsgemäßen elektronischen Bauelements dargestellt. In diesem Ausführungsbeispiel ist die elektrisch leitende Struktur 2 als Induktivitätsstruktur ausgebildet. In einer einzigen Metallisierungsebene ist eine spiralförmige Metallbahn MB4 ausgebildet, die eine rechteckige Form aufweist. Die Metallbahn MB4 ist in der in dieser Fig. 3 nicht dargestellten ersten Isolationsschicht 1 integriert. Die Induktivitätsstruktur in Form der spiralförmigen Metallbahn MB4 kann auch in mehreren Metallisierungsebenen ausgebildet sein, wobei, wie auch im Ausführungsbeispiel der Kapazitätsstruktur gemäß Figuren 1 und 2, sich die gesamte Metallbahn MB4 in der ersten Isolationsschicht 1 erstreckt. Die Metallbahn MB4 ist an ihrem inneren Ende der Spirale mittels Via-Verbindungen V mit einem Kontakt-Metallstreifen KM kontaktiert, welcher mit einem Versorgungsspannungspotenzial verbunden ist. Der Kontakt-Metallstreifen KM ist in einer höheren Metallisierungsebene (in y-Richtung entsprechend der Figuren 1, 2 und 4 betrachtet) als die Metallisierungsebene in der die Metallbahn MB4 ausgebildet ist hergestellt und ist in der zweiten Isolationsschicht ausgebildet. Unter einer höher angeordneten Metallisierungsebene wird hier eine derartige Metallisierungsebene verstanden, welche von einem Substrat eines integrierten Schaltkreises, auf dem das erfindungsgemäße elektronische Bauelement EB angeordnet ist, in gleicher Richtung betrachtet weiter entfernt ist als die Metallisierungsebene in der die elektrisch leitende Struktur 2 in Form der Kapazitätsstruktur und/oder der Induktivitätsstruktur ausgebildet ist. Auch in diesem Beispiel kann die zweite Isolationsschicht identisch mit der in Fig. 1 dargestellten dritten Isolationsschicht 4a sein.

Das äußere zweite Ende der spiralförmigen Metallbahn MB4 ist ebenfalls mit einer nicht-dargestellten Via-Verbindung und einem weiteren nicht-dargestellten Kontakt-Metallstreifen KM mit Massepotenzial elektrisch verbunden. Dieser weitere Metallstreifen KM kann in der ersten Isolationsschicht 1 (Fig.1) oder der zweiten oder einer gegebenenfalls vorhandenen höheren (in positiver y-Richtung betrachtet) Isolationsschicht angeordnet sein.

Von untergeordneter Bedeutung ist die geometrische Flächengestaltung der elektrisch leitenden Struktur 2 in der Draufsicht (Fig. 3). So kann die spiralförmige Metallbahn gemäß Fig. 3 auch beispielsweise quadratisch ausgebildet sein. Ebenso kann die Kapazitätsstruktur gemäß Fig. 2 bei einer Draufsicht in negativer y-Richtung beispielsweise einen rechteckigen oder quadratischen Umriss aufweisen. In besonders vorteilhafter Weise ist die geometrische Flächengestaltung, insbesondere der Umriss und damit die Ausmaße der elektrisch leitenden Struktur derart gewählt, dass die Fläche des Bonding-Bereichs BB der ersten Metallschicht 5 bei einer Projektion auf die Umrissfläche der elektrisch leitenden Struktur vollständig in dieser Umrissfläche der elektrisch leitenden Struktur enthalten ist.

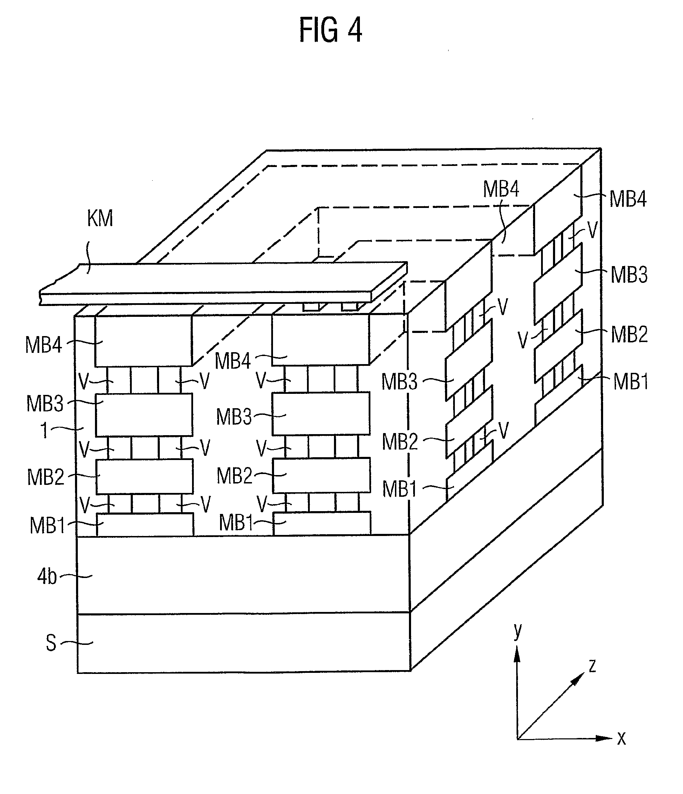

In Fig. 4 ist eine perspektivische Schnittdarstellung des in Fig. 3 eingezeichneten Bereichs I gezeigt. In Fig. 4 ist in die erste Isolationsschicht 1 eine als Induktivitätsstruktur ausgebildete elektrisch leitende Struktur 2 integriert, welche in vier Metallisierungsebenen ausgebildet ist. In den Metallisierungsebenen ist jeweils eine der Metallbahnen MB1 bis MB4 ausgebildet, die jeweils über Via-Verbindungen V elektrisch miteinander kontaktiert sind. Die Via-Verbindungen können als vertikale Säulen oder als langgestreckte, parallel zu den Metallbahnen MB1 bis MB4 verlaufende Stränge ausgebildet sein. Aufgrund der sogenannten hierarchischen Interconnect-Technologie können die Metallbahnen MB1 bis MB4 mit zunehmenden Abstand (positive y-Richtung) zum Substrat S mit einem größeren Querschnitt (x-y-Ebene) und mit zunehmenden Abstand (positive y-Richtung) zueinander ausgebildet werden. Auf der ersten Isolationsschicht 1 kann unmittelbar angrenzend die nicht-dargestellte zweite Isolationsschicht ausgebildet sein, in der der Kontakt-Metallstreifen KM angeordnet ist. Darüber können Schichten 3 bis 10 entsprechend Fig. 1 angeordnet sein. Wie in Fig. 4 zu erkennen ist, ist auch die Induktivitätsstruktur 2 in Form der Metallspulen MB1 bis MB4 derart ausgebildet, dass die Oberflächenbereiche der Metallbahn MB4 und die Oberflächenbereiche der Metallbahn MB1 eben (in x-z-Ebene betrachtet) mit der Oberfläche der ersten Isolationsschicht 1 ausgebildet sind. Der Verlauf der Metallbahn MB4 innerhalb der ersten Isolationsschicht 1 ist gestrichelt und beispielhaft für den Verlauf der Metallbahnen MB1 bis MB3 dargestellt. Die erste Isolationsschicht 1 grenzt unmittelbar an die Isolationsschicht 4b an, wobei die Isolationsschicht 4b auf dem Substrat S ausgebildet ist.

Es kann auch vorgesehen sein, die elektrisch leitende Struktur 2 derart auszubilden, dass sie eine erste Teil-Struktur entsprechend einer Kapazitätsstruktur gemäß dem Ausführungsbeispiel in den Figuren 1 oder 2 und eine zweite Teil-Struktur entsprechend einer Induktivitätsstruktur gemäß dem Beispiel in den Figuren 3 oder 4 aufweist. In diesem Falle kann mit der elektrisch leitenden Struktur eine mechanische Stabilisierungsstruktur und zwei passive elektronische Bauelemente realisiert werden. Die Teil-Strukturen können nebeneinander oder übereinander angeordnet sein.

Die elektrisch leitende Struktur kann in vielfältiger Weise realisiert werden und ist nicht auf die gezeigten Ausführungsbeispiele beschränkt. So kann die elektrisch leitende Struktur auch in zwei oder mehr als vier Metallisierungsebenen ausgebildet sein. Ebenso können die Isolationsschichten aus jeweils mehreren Schichten aufgebaut sein. Es kann auch vorgesehen sein, die Kapazitätsstruktur gemäß Figuren 1 und 2 lediglich in einer Metallisierungsebene auszubilden und bspw. nur die Metallstreifen M11, M12 und M13 zu erzeugen.

Durch das erfindungsgemäße elektronische Bauelement kann durch das geeignete Ausbilden (Formgebung) und Anordnen einer einzigen in einer Isolationsschicht, insbesondere einer dielektrischen Schicht aus einem Material mit niedriger Dielektrizitätskonstante, ausgebildeten elektrisch leitenden Struktur sowohl ein passives Bauelement als auch eine mechanische Stütz- bzw. Stabilisierungsstruktur für das elektronische Bauelement EB, insbesondere für die Isolationsschicht in der die elektrisch leitende Struktur ausgebildet ist, gegen Schädigung bei mechanischer Krafteinwirkung, bspw. beim Bonden oder der Montage des Bauelements in ein Gehäuse, erzeugt werden. Dadurch wird der im elektronischen Bauelement EB ansonsten im Wesentlichen nicht benötigte Bereich unter der Bond-Pad-Schicht optimal ausgenutzt, woraus eine Bauelementtopologie mit minimierten Ausmaßen und optimierter Funktionsnutzung resultiert.

Wesentlich für die Erfindung ist somit, dass die elektrisch leitende Struktur eine Doppelfunktion einerseits in Form zumindest einer Kapazitätsstruktur und andererseits als eine mechanischen Stabilisierungsstruktur für das elektronische Bauelement EB und insbesondere für die erste Isolationsschicht aufweist.

## Patentansprüche

1. Elektronisches Bauelement mit
- einer ersten Isolationsschicht (1),
- einer oberen Metallschicht (5), die einen Bonding-Bereich (BB) aufweist und die auf der ersten Isolationsschicht (1) ausgebildet ist,
- einer in die erste Isolationsschicht (1) integrierten, vertikal unterhalb des Bonding-Bereichs (BB) angeordneten elektrisch leitenden Struktur (2), die die Isolationsschicht (1) bei mechanischer Krafteinwirkung; insbesondere beim Bonden der oberen Metallschicht (5) und/oder der Montage des elektronischen Bauelements (EB), mechanisch stabilisiert und als passives elektronisches Bauelement ausgebildet ist,
- einer zweiten Isolationsschicht (4a), die zwischen der ersten Isolationsschicht (1) und der oberen Metallschicht (5) angeordnet ist, und
- einer elektrisch leitenden Abschirmschicht (3), die zwischen und elektrisch isoliert von der oberen Metallschicht (5) und der elektrisch leitenden Struktur (2) ausgebildet ist,
wobei die elektrisch leitende Struktur (2) als Kapazitätsstruktur ausgebildet ist und mindestens zwei Metallisierungsebenen aufweist, wobei in der ersten Metallisierungsebene parallel zueinander angeordnete und voneinander isolierte Streifen (M11, M12, M13) ausgebildet sind, welche zu den in der zweiten Metallisierungsebene parallel zueinander angeordneten und voneinander isolierten Streifen (M21, M22, M23) deckungsgleich angeordnet sind, wobei die in vertikaler Richtung jeweils übereinander angeordneten Streifen (M11, M21; M12, M22; M13, M23) in den beiden Metallisierungsebenen durch Via-Verbindungen (V) elektrisch miteinander verbunden sind,
die zweite Isolationsschicht (4a) aus einem isolierenden Material hergestellt ist, das eine höhere mechanische Stabilität aufweist, als ein isolierendes Material, aus dem die erste Isolationsschicht (1) ausgebildet ist,
die Abschirmschicht (3) in der zweiten Isolationsschicht (4a) ausgebildet ist,
die obere Metallschicht (5) über einen Kontaktbereich (6) mit einem elektrisch leitenden Bereich (7) elektrisch verbunden ist, wobei der Kontaktbereich (6) und der elektrisch leitende Bereich (7) in der zweiten Isolationsschicht (4a) angeordnet sind, und
der Kontaktbereich (6) und der zweite elektrisch leitende Bereich (7) horizontal versetzt zur elektrisch leitenden Struktur (2) und zum Bonding-Bereich (BB) der oberen Metallschicht (5) angeordnet sind.

2. Elektronisches Bauelement nach Anspruch 1,
**dadurch gekennzeichnet, dass** die erste Isolationsschicht (1) aus einem Material mit einer Dielektrizitätskonstante kleiner 4, insbesondere kleiner 3, ausgebildet ist.

3. Elektronisches Bauelement nach Anspruch 1 oder 2,
**dadurch gekennzeichnet, dass** dass die Ausmaße der elektrisch leitenden Struktur (2) in einer Ebene parallel zur oberen Metallschicht (5) mindestens gleich groß dem Bonding-Bereich (BB) sind.

4. Elektronisches Bauelement nach einem der vorhergehenden Ansprüche,
**dadurch gekennzeichnet, dass** die Abschirmschicht (3) als zusammenhängende Platte oder als Gitterstruktur ausgebildet ist.

5. Elektronisches Bauelement nach einem der vorhergehenden Ansprüche,
**dadurch gekennzeichnet, dass** die der elektrisch leitenden Struktur (2) zugewandte Fläche der Abschirmschicht (3) mindestens gleich groß der der Abschirmschicht (3) zugewandten Fläche der leitenden Struktur (2) ist und derart angeordnet ist, dass bei einer Projektion der Flächen aufeinander diese Fläche der Abschirmschicht (3) diese Fläche der leitenden Struktur (2) vollständig überdeckt.

6. Elektronisches Bauelement nach einem der vorhergehenden Ansprüche,
**dadurch gekennzeichnet, dass** die elektrisch leitende Struktur (2) mit den horizontalen Oberflächen der ersten Isolationsschicht (1) eben ausgebildet ist und Oberflächenbereiche der ersten leitenden Struktur (2) Teilbereiche der horizontalen Oberflächen der ersten Isolationsschicht (1) bilden.

7. Integrierter Schaltkreis mit einem Substrat und einem auf dem Substrat ausgebildeten elektronischen Bauelement (EB) nach einem oder mehreren der vorhergehenden Ansprüche.

## Claims

1. Electronic component having
- a first insulation layer (1),
- an upper metal layer (5), which has a bonding region (BB) and which is formed on the first insulation layer (1),
- an electrically conductive structure (2), which is integrated into the first insulation layer (1), is arranged vertically underneath the bonding region (BB), mechanically stabilizes the insulation layer (1) under the action of mechanical force, in particular during the bonding of the upper metal layer (5) and/or the mounting of the electronic component (EB), and is formed as a passive electronic component,
- a second insulation layer (4a), which is arranged between the first insulation layer (1) and the upper metal layer (5), and
- an electrically conductive screening layer (3), which is formed between and in a manner electrically insulated from the upper metal layer (5) and the electrically conductive structure (2),
wherein
the electrically conductive structure (2) is formed as a capacitance structure and has at least two metallization planes, strips (M11, M12, M13) arranged parallel to one another and insulated from one another being formed in the first metallization plane, which strips are arranged congruently with respect to the strips (M21, M22, M23) arranged parallel to one another and insulated from one another in the second metallization plane, the strips (M11, M21; M12, M22; M13, M23) arranged respectively one above the other in the vertical direction in the two metallization planes being electrically connected to one another by via connections (V),
the second insulation layer (4a) is produced from an insulating material having a higher mechanical stability than an insulating material from which the first insulation layer (1) is formed,
the screening layer (3) is formed in the second insulation layer (4a),
the upper metal layer (5) is electrically connected to an electrically conductive region (7) by means of a contact region (6), the contact region (6) and the electrically conductive region (7) being arranged in the second insulation layer (4a), and
the contact region (6) and the second electrically conductive region (7) are arranged horizontally offset with respect to the electrically conductive structure (2) and with respect to the bonding region (BB) of the upper metal layer (5).

2. Electronic component according to Claim 1,
**characterized in that**
the first insulation layer (1) is formed from a material having a dielectric constant of less than 4, in particular less than 3.

3. Electronic component according to Claim 1 or 2,
**characterized in that**
the dimensions of the electrically conductive structure (2) in a plane parallel to the upper metal layer (5) are at least identical in magnitude to the bonding region (BB).

4. Electronic component according to one of the preceding claims,
**characterized in that**
the screening layer (3) is formed as a contiguous plate or as a grid structure.

5. Electronic component according to one of the preceding claims,
**characterized in that**
that area of the screening layer (3) which faces the electrically conductive structure (2) is at least identical in magnitude to that area of the conductive structure (2) which faces the screening layer (3), and is arranged in such a way that when the areas are projected on one another, the said area of the screening layer (3) completely covers the said area of the conductive structure (2).

6. Electronic component according to one of the preceding claims,
**characterized in that**
the electrically conductive structure (2) is formed in a planar manner with the horizontal surfaces of the first insulation layer (1) and surface regions of the first conductive structure (2) form partial regions of the horizontal surfaces of the first insulation layer (1).

7. Integrated circuit having a substrate and an electronic component (EB) according to one or more of the preceding claims, which electronic component is formed on the substrate.

## Revendications

1. Composant électronique présentant
- une première couche isolante (1),
- une couche métallique supérieure (5) qui présente une zone de liaison (BB) et formée sur la première couche isolante (1),
- une structure électriquement conductrice (2), intégrée dans la première couche isolante (1), disposée verticalement en dessous de la zone de liaison (BB), stabilisant mécaniquement la couche isolante (1) en cas d'action d'une force mécanique, en particulier lors de la liaison de la couche métallique supérieure (5) et/ou du montage du composant électronique (EB) et configurée comme composant électronique passif,
- une deuxième couche isolante (4a) disposée entre la première couche isolante (1) et la couche métallique supérieure (5) et
- une couche électriquement conductrice de blindage (3) formée entre la couche métallique supérieure (5) et la structure électriquement conductrice (2) et isolée électriquement vis-à-vis de ces dernières,
la structure électriquement conductrice (2) étant configurée comme structure capacitive et présentant au moins deux plans de métallisation, des rubans (M11, M12, M13) disposés parallèlement les uns aux autres dans le premier plan de métallisation et isolés les uns des autres étant formés et recouvrant les rubans (M21, M22, M23) disposés parallèlement les uns aux autres dans le deuxième plan de métallisation et isolés les uns des autres, les rubans (M11, M21; M12, M22; M13, M23) disposés les uns au-dessus des autres dans la direction verticale dans les deux plans de métallisation étant raccordés électriquement les uns aux autres par des liaisons de traversée (V),
la deuxième couche isolante (4a) étant réalisée en un matériau dont la stabilité mécanique est plus élevée que celle du matériau isolant duquel la première couche isolante (1) est formée,
la couche de blindage (3) étant formée dans la deuxième couche isolante (4a),
la couche métallique supérieure (5) étant raccordée électriquement par une zone de contact (6) à une zone électriquement conductrice (7), la zone de contact (6) et la zone électriquement conductrice (7) étant disposées dans la deuxième couche isolante (4a) et
la zone de contact (6) et la deuxième zone électriquement conductrice (7) étant disposées en décalage horizontal par rapport à la structure électriquement conductrice (2) et par rapport à la zone de liaison (BB) de la couche métallique supérieure (5).

2. Composant électronique selon la revendication 1, **caractérisé en ce que** la première couche isolante (1) est formée d'un matériau dont la constante diélectrique est inférieure à 4 et en particulier inférieure à 3.

3. Composant électronique selon les revendications 1 ou 2, **caractérisé en ce que** les dimensions de la structure électriquement conductrice (2) dans un plan parallèle à la couche métallique supérieure (5) sont au moins aussi grandes que celles de la zone de liaison (BB).

4. Composant électronique selon l'une des revendications précédentes, **caractérisé en ce que** la couche de blindage (3) est configurée comme plaque continue ou comme structure en grille.

5. Composant électronique selon l'une des revendications précédentes, **caractérisé en ce que** la surface de la couche de blindage (3) tournée vers la structure électriquement conductrice (2) est au moins aussi grande que la surface de la structure électriquement conductrice (2) tournée vers la couche de blindage (3) et est disposée de telle sorte que dans une projection des surfaces l'une sur l'autre, cette surface de la couche de blindage (3) recouvre complètement cette surface de la structure conductrice (2).

6. Composant électronique selon l'une des revendications précédentes, **caractérisé en ce que** la structure électriquement conductrice (2) est formée sur le même plan que les surfaces horizontales de la première couche isolante (1) et **en ce que** les parties de surface de la première structure conductrice (2) forment des parties des surfaces horizontales de la première couche isolante (1).

7. Circuit intégré doté d'un substrat et d'un composant électronique (EB) formé sur le substrat et selon l'une ou plusieurs des revendications précédentes.
